Europäisches Patentamt

European Patent Office

Office européen des brevets

(19)

(11) Numéro de publication : **0 098 775**
**B1**

(12) **FASCICULE DE BREVET EUROPÉEN**

(45) Date de publication du fascicule du brevet :
09.09.87

(51) Int. Cl.⁴ : **H 01 L 21/76, H 01 L 21/31**

(21) Numéro de dépôt : 83401332.8

(22) Date de dépôt : 28.06.83

(54) Procédé de réalisation de l'oxyde de champ d'un circuit intégré.

(30) Priorité : 01.07.82 FR 8211570

(43) Date de publication de la demande :
18.01.84 Bulletin 84/03

(45) Mention de la délivrance du brevet :
09.09.87 Bulletin 87/37

(84) Etats contractants désignés :
BE CH DE GB IT LI NL

(56) Documents cités :
EP-A- 0 035 111
EP-A- 0 044 082
EP-A- 0 073 370
IBM TECHNICAL DISCLOSURE BULLETIN, vol. 23,
no. 4, septembre 1980, pages 1405-1408, New York,
USA; C.T. HORNG et al.: "Device isolation by using a
narrow S102 trench"
IEEE TRANSACTIONS ON ELECTRON DEVICES, vol.
ED-29, no. 4, avril 1982, pages 541-547, New York,
USA; K.L. WANG et al.: "Direct moat isolation for
VLSI"
INTERNATIONAL ELECTRON DEVICES MEETING,
Washington, D.C., 7-9 décembre 1981, IEEE, pages
384-387, New York, USA; K. KUROSAWA et al.: "A
new bird's-beak free field isolation technology for
VLSI devices"
IEEE JOURNAL OF SOLID-STATE CIRCUITS, vol. SC-
17, no. 2, April 1982, pages 191-197, New York, USA;
N. MATSUKAWA et al.: "Selective polysilicon oxidation technology for VLSI isolation"
IBM TECHNICAL DISCLOSURE BULLETIN, vol. 21,
no. 5, octobre 1978, pages 1868-1869, New York, USA;
T.A. BARTUSH et al.: "Dielectric isolation planarization"

(73) Titulaire : **COMMISSARIAT A L'ENERGIE ATOMIQUE**
**Etablissement de Caractère Scientifique Technique**
**et Industriel**
**31/33, rue de la Fédération**
**F-75015 Paris (FR)**

(72) Inventeur : **Jeuch, Pierre**
**49, Avenue Louis Armand**
**F-38170 Seyssins (FR)**
Inventeur : **Parrens, Pierre**
**15, boulevard Maréchal Leclerc**
**F-38000 Genoble (FR)**

(74) Mandataire : **Mongrédien, André et al**
**c/o BREVATOME 25, rue de Ponthieu**
**F-75008 Paris (FR)**

**IBM TECHNICAL DISCLOSURE BULLETIN, Vol.25,
May 1983, p.6611-6614**
Le dossier contient des informations techniques présentées postérieurement au dépôt de la demande et
ne figurant pas dans le présent fascicule.

2

## Description

La présente invention a pour objet un procédé de réalisation de l'oxyde de champ d'un circuit intégré. Elle s'applique en particulier dans le domaine de la fabrication des circuits intégrés MOS.

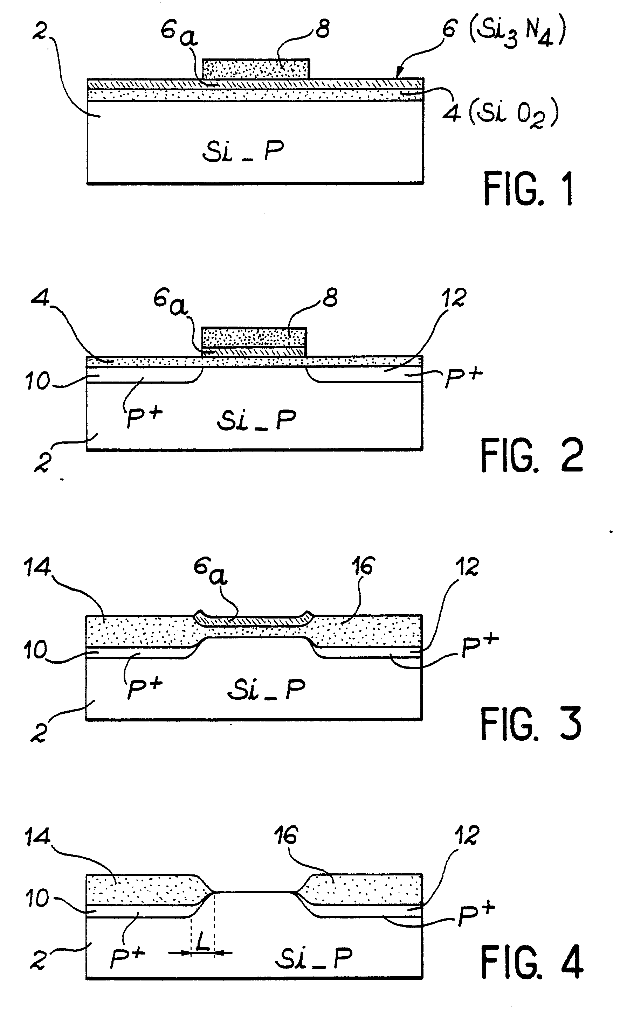

L'un des principaux procédés de réalisation de l'oxyde de champ connus est celui généralement appelé « Procédé LOCOS ». Sur les figures 1 à 4, on a représenté les différentes étapes de ce procédé LOCOS.

La première étape de ce procédé consiste, comme représenté sur la figure 1, à faire croître thermiquement sur un substrat en silicium 2, par exemple de type P, une couche d'oxyde de silicium 4, de faible épaisseur, c'est-à-dire de l'ordre de 0,07 micromètre, puis à déposer une couche de nitrure de silicium 6 sur la couche d'oxyde 4, présentant généralement une épaisseur voisine de 0,08 micromètre. Après réalisation d'un masque de résine 8 sur la région 6a de la couche de nitrure de silicium 6, située au-dessus de la région du substrat dans laquelle sera réalisé ultérieurement le composant élémentaire du circuit intégré, par exemple sur la région centrale de la couche de nitrure de silicium comme représenté sur la figure 1, on réalise une gravure de la couche de nitrure de silicium 6 par exemple par une attaque par plasma. La structure ainsi obtenue est représentée sur la figure 2.

Après gravure de la couche de nitrure de silicium 6, on implante, à travers la couche d'oxyde 4, des ions donnant un dopage du même type que celui du substrat. Cette implantation d'ions permet d'obtenir, dans le substrat 2, deux régions latérales 10 et 12, par exemple de type P+ dans le cas d'un substrat de type P et d'une implantation d'ions de bore. Cette implantation est effectuée avec une dose de $2.10^{12}$ atomes/cm² et à une énergie de 140 keV, par exemple.

On élimine ensuite le masque de résine 8. L'étape suivante consiste à réaliser l'oxyde de champ par une oxydation thermique du silicium, les zones actives où l'on veut réaliser les composants élémentaires étant masquées par la région 6a de la couche de nitrure de silicium 6 au cours de cette oxydation. On obtient ainsi deux régions latérales 14 et 16 de silice présentant une épaisseur généralement comprise entre 0,6 et 0,8 micromètre.

Ce procédé se termine en éliminant la région 6a de la couche de nitrure de silicium 6 et la région de la couche d'oxyde 4, située au-dessus de la région du substrat 2 dans laquelle sera réalisé ultérieurement le composant. Cette élimination se fait par exemple par une attaque chimique. La structure ainsi obtenue est représentée sur la figure 4.

Ce procédé de réalisation de l'oxyde de champ d'un circuit intégré présente un certain nombre d'inconvénients.

En particulier, l'étape d'oxydation thermique de façon à obtenir les régions 14 et 16 en silice est une étape longue et fastidieuse. En effet, cette oxydation thermique est réalisée à une température relativement peu élevée, de l'ordre de 900 °C, et ce, pendant environ 10 heures.

De plus, ce traitement thermique prolongé conduit à une diffusion des ions implantés dans les régions 10 et 12 du substrat. Cette redistribution des ions, nécessite des implantations à assez forte dose.

Ce procédé de réalisation de l'oxyde de champ présente de plus, l'inconvénient majeur de limiter la densité d'intégration des circuits intégrés. En effet, l'oxyde de champ, réalisé par ce procédé, présente une importante extension latérale, référencée L sur la figure 4.

La présente invention a justement pour objet un procédé de réalisation de l'oxyde de champ d'un circuit intégré permettant de remédier à ces différents inconvénients. Ce procédé permet en particulier d'éviter un traitement thermique prolongé, de diminuer la dose des ions à implanter et, d'augmenter la densité d'intégration des circuits intégrés.

De façon plus précise, l'invention a pour objet un procédé de réalisation de l'oxyde de champ d'un circuit intégré dans des premières régions d'un substrat semi-conducteur dopé adjacentes à une seconde région dudit substrat dans laquelle sera réalisé un composant actif du circuit intégré, caractérisé en ce qu'il comprend les étapes successives suivantes :

a) dépôt d'une couche protectrice sur l'ensemble du substrat,

b) masquage de la région de la couche protectrice, située sur la seconde région du substrat, avec de la résine,

c) élimination des régions de la couche protectrice, situées au-dessus des premières régions du substrat,

d) réalisation d'une première gravure des premières régions du substrat sur une hauteur d'au plus 0,8 μm,

e) implantation d'ions dans les premières régions du substrat restantes, donnant un dopage du même type que celui du substrat, en utilisant la résine comme masque,

f) élimination du masque de résine,

g) dépôt d'une couche d'isolant sur l'ensemble du substrat,

h) dépôt d'une couche de résine sur la couche d'isolant, et

i) réalisation d'une deuxième gravure simultanée de la couche de résine et de la couche d'isolant jusqu'à l'élimination totale de la région de la couche d'isolant, située au-dessus de la seconde couche du substrat, et

j) élimination de la région de la couche protectrice située sur la seconde région du substrat.

De préférence, ladite deuxième gravure de la couche de résine et de la couche d'oxyde est réalisée avec des vitesses d'attaque identiques pour la résine et l'isolant. Selon un mode préféré de mise en œuvre de l'invention, cette deuxième gravure est faite par gravure ionique réactive à l'aide d'un mélange gazeux contenant du trifluorométhane ($CHF_3$) et de l'oxygène dans des proportions adéquates. On peut également utiliser d'autres gaz tels qu'un mélange de tétrafluorure de carbone ($CF_4$) et d'oxygène, ou bien de l'hexafluorure de soufre ($SF_6$).

La présence de cette couche protectrice, réalisée notamment en nitrure de silicium, permet de protéger la surface du substrat semi-conducteur des différentes gravures évitant ainsi la formation de défauts dans les zones actives du substrat et la contamination de celui-ci.

Selon un autre mode préféré de mise en œuvre du procédé de l'invention, l'étape de gravure d) est réalisée par un procédé de gravure anisotrope telle par exemple une gravure ionique réactive. Une telle gravure anisotrope permet un meilleur contrôle des dimensions des zones actives, et donc une densité d'intégration accrue.

Selon un mode préféré de mise en œuvre de l'invention, on réalise une gravure en pente de la première région du substrat (20) au cours de l'étape d).

Selon un procédé de mise en œuvre avantageux de l'invention, on réalise une gravure en pente à l'aide d'un profil en pente du masque de résine réalisé au cours de l'étape b, et d'une gravure ionique réactive anisotrope.

Selon un mode préféré de mise en œuvre de l'invention, on réalise après l'étape f et avant l'étape g, une oxydation thermique du substrat par exemple sur une épaisseur de l'ordre de 0,05 à 0,1 µm. Une telle couche d'oxyde thermique permet en effet d'assurer une interface de bonne qualité entre le substrat et la couche d'isolant déposée par la suite.

D'autres caractéristiques et avantages de l'invention ressortiront mieux de la description qui va suivre, donnée à titre illustratif mais non limitatif, en référence aux figures annexées, dans lesquelles :

les figures 1 à 4, déjà décrites, représentent schématiquement, les différentes étapes d'un procédé de réalisation de l'oxyde de champ selon l'art antérieur, et

les figures 5 à 10 représentent, schématiquement, les différentes étapes du procédé de réalisation de l'oxyde de champ conformément à l'invention.

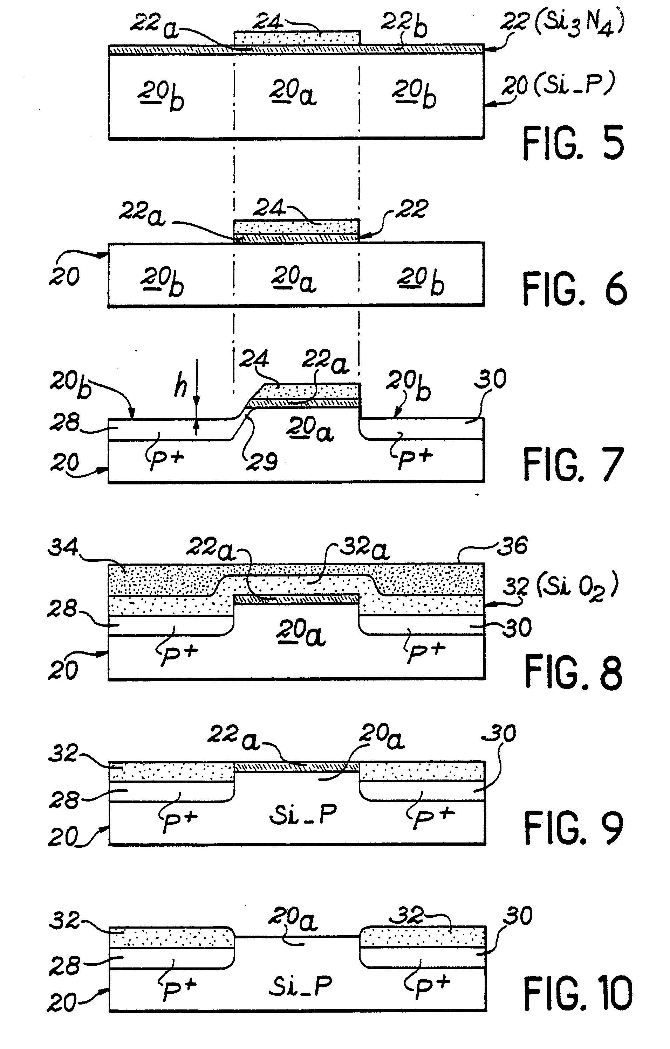

En se référant à la figure 5, la première étape du procédé, selon l'invention, consiste à déposer sur un substrat semi-conducteur dopé 20, par exemple en silicium de type P, une couche protectrice 22, réalisée par exemple en nitrure de silicium. Cette couche protectrice 22 permet d'éviter toute contamination ultérieure du substrat 20 lors des différentes étapes du procédé selon l'invention. Cette couche protectrice 22, déposée par exemple par la technique de dépôt chimique en phase vapeur, à basse pression ou non, présente par exemple une épaisseur de 0,1 micron.

On réalise ensuite selon les procédés classiques de la microlithographie un masque de résine 24, sur la couche protectrice 22 de façon à ne masquer que la région 22a de cette couche 22, située sur la région 20a du substrat semi-conducteur 20, dans laquelle sera réalisé ultérieurement le composant actif, puis on réalise une gravure anisotrope de la couche protectrice 22 par exemple au moyen d'une gravure ionique réactive par $SF_6$ (hexafluorure de soufre). Cette gravure permet d'éliminer les régions 22b de la couche protectrice 22, situées au-dessus des régions 20b du substrat semi-conducteur 20, dans lesquelles on va réaliser l'oxyde de champ selon l'invention. La structure obtenue, après cette gravure, est représentée sur la figure 6.

Après gravure de la couche protectrice 22, on réalise, une gravure de préférence anisotrope des régions 20b du substrat sur une hauteur h d'environ 0,8 micron. Cette gravure se fait par exemple par gravure ionique réactive par $SF_6$.

Afin d'obtenir un profil incliné, on peut soumettre la couche de résine 24, avant de graver la couche protectrice et le substrat, à un traitement thermique, c'est-à-dire à un chauffage de l'ordre de 120 °C, ou bien à l'action d'un plasma d'oxygène de façon à effectuer une légère attaque de la résine. Ce traitement thermique, où cette légère attaque permet d'obtenir un profil incliné du masque de résine 24, entraînant, lors de la gravure anisotrope du substrat, un profil incliné de la région 20a du substrat. La pente de ce profil sera fonction de la pente du profil du masque de résine 24 et des vitesses d'attaque respectives de la résine et du substrat au cours de la gravure de ce dernier.

L'étape suivante du procédé selon l'invention consiste, en utilisant toujours le même masque 24, disposé sur la région 22a de la couche protectrice 22, à implanter des ions, dans ce qui reste des régions 20b du substrat, ces ions donnant un dopage du même type que celui du substrat. Dans le cas d'un substrat en silicium de type P, cette implantation peut être réalisée avec des ions de bore à une énergie de 50 keV et à une dose de $10^{12}$ atomes/$cm^2$. Cette implantation permet d'obtenir des régions latérales 28 et 30 par exemple de type P+.

L'utilisation d'un profil incliné pour la région 20a du substrat conduit, lors de l'implantation ionique, à la formation sur les flancs de la région 20a d'une région 29 implantée, par exemple de type P+ comme représenté sur la figure 7. Lors de la fabrication d'un transistor MOS, l'existence de cette région implantée permet d'éviter la création d'un canal parasite sur les flancs du transistor.

Après cette implantation ionique et l'élimination du masque de résine 24, on réalise une oxydation thermique du substrat (non représentée) sur une épaisseur de 0,05 µm par exemple. Une telle oxydation pourra être réalisée à 900 °C pendant 1 heure. On dépose ensuite, comme représenté sur la figure 8, sur l'ensemble du substrat 20 et sur la région 22a de la couche de nitrure de silicium restante, par exemple par la technique de dépôt chimique en phase vapeur, à basse pression ou non, une couche d'isolant 32, réalisée par exemple en silice. Cette couche d'isolant 32 présente par exemple une épaisseur de 1 micron. Le fait de réaliser cette couche de silice 32 par dépôt et non par oxydation thermique permet d'utiliser, lors de l'implantation ionique, une quantité moins importante d'ions que celle utilisée lors des procédés de réalisation de l'oxyde de champ de l'art antérieur, étant donné que la diffusion des ions dans le substrat est totalement évitée. Par ailleurs, cela permet d'éliminer totalement les extensions latérales de l'oxyde et par conséquent d'augmenter la densité d'intégration des circuits intégrés.

L'étape suivante du procédé consiste à recouvrir la couche d'oxyde 32 d'une couche de résine 34. Cette couche de résine 34 qui peut être réalisée en une résine telle que les résines couramment utilisées en photolithographie présente par exemple une épaisseur de 1,5 μm. Après dépôt, la couche de résine 34 peut être soumise à un traitement thermique, par exemple à un chauffage à une température de 200 °C pendant 1/2 heure, afin d'obtenir un bon étalement de cette couche de résine et donc une surface plane 36, comme représenté sur la figure 8.

On réalise ensuite une gravure simultanément de la couche de résine 34 et de la couche d'oxyde 32 avec des vitesses d'attaque identiques pour la résine et l'oxyde jusqu'à élimination totale de la région 32a de la couche d'oxyde 32, située au-dessus de la région 20a du substrat ; le contrôle de fin de gravure se fait par tout moyen connu. La structure obtenue est représentée sur la figure 9. Cette gravure peut être réalisée par exemple par un mélange de tri ou tétrafluorométhane (CHF$_3$, CF$_4$) et d'oxygène ; les composés fluorés servant à la gravure de l'oxyde et l'oxygène à la gravure de la résine. Pour cette gravure on peut aussi utiliser de l'hexafluorure de soufre (SF$_6$).

La dernière étape du procédé selon l'invention consiste à éliminer la région 22a de la couche de nitrure de silicium restante, par exemple en gravant ladite région au moyen d'une gravure chimique. La structure finale obtenue est représentée sur la figure 10.

## Revendications

1. Procédé de réalisation de l'oxyde de champ d'un circuit intégré dans des premières régions (20b) d'un substrat semi-conducteur dopé (20) adjacentes à une seconde région (20a) dudit substrat dans laquelle sera réalisé un composant actif du circuit intégré, caractérisé en ce qu'il comprend les étapes successives suivantes :

a) dépôt d'une couche protectrice (22) sur l'ensemble du substrat (20),

b) masquage de la région (22a) de la couche protectrice, située sur la seconde région (20a) du substrat, avec de la résine (24),

c) élimination des régions (22b) de la couche protectrice, situées au-dessus des premières régions (20b) du substrat (20),

d) réalisation d'une première gravure des premières régions (20b) du substrat (20) sur une hauteur d'au moins 0,8 μm,

e) implantation d'ions dans les premières régions (20b) du substrat restantes, donnant un dopage du même type que celui du substrat (20), en utilisant la résine comme masque,

f) élimination du masque de résine (24),

g) dépôt d'une couche d'isolant (32) sur l'ensemble du substrat (20),

h) dépôt d'une couche de résine (34) sur la couche d'isolant (32), et

i) réalisation d'une deuxième gravure simultanée de la couche de résine (34) et de la couche d'isolant (32) jusqu'à élimination totale de la région (32a) de la couche d'isolant, située au-dessus de la seconde région (20a) du substrat (20), et

j) élimination de la région (22a) de la couche protectrice située sur la seconde région (20a) du substrat (20).

2. Procédé de réalisation selon la revendication 1, caractérisé en ce que l'on réalise ladite deuxième gravure avec des vitesses d'attaque identiques pour la résine (34) et l'isolant (32).

3. Procédé de réalisation selon l'une quelconque des revendications 1 et 2, caractérisé en ce que ladite deuxième gravure est une gravure ionique réactive, dans un mélange gazeux, contenant soit du trifluorométhane et de l'oxygène, soit du tétrafluorure de carbone CF$_4$ et de l'oxygène, soit de l'hexafluorure de soufre SF$_6$.

4. Procédé de réalisation selon l'une quelconque des revendications 1 à 3, caractérisé en ce que l'étape c est réalisée à l'aide d'une gravure ionique réactive.

5. Procédé de réalisation selon l'une quelconque des revendications 1 à 4, caractérisé en ce que l'étape j est effectuée à l'aide d'une gravure chimique.

6. Procédé de réalisation selon l'une quelconque des revendications 1 à 5, caractérisé en ce que l'on réalise une gravure en pente des premières régions (20b) du substrat (20) au cours de l'étape d.

7. Procédé de réalisation selon la revendication 6, caractérisé en ce que l'on réalise une gravure en pente à l'aide d'un profil en pente du masque de résine (24), réalisé au cours de l'étape b, et d'une gravure ionique réactive anisotrope.

8. Procédé de réalisation selon la revendication 7, caractérisé en ce que, pour obtenir un profil en pente du masque de résine (24), on soumet cette résine (24) à un traitement thermique après son développement.

9. Procédé de réalisation selon la revendication 7, caractérisé en ce que, pour obtenir un profil en pente du masque de résine (24), on soumet cette résine (24) à un plasma d'oxygène, après son développement.

10. Procédé de réalisation selon l'une quelconque des revendications 1 à 9, caractérisé en ce que, après l'étape f et avant l'étape g, on réalise une oxydation thermique du substrat (20).

11. Procédé de réalisation selon l'une quelconque des revendications 1 à 10, caractérisé en ce que la couche d'isolant (32) est en silice.

12. Procédé de réalisation selon l'une quelconque des revendications 1 à 11, caractérisé en ce que la couche protectrice (22) est en nitrure de silicium.

### Claims

1. Process for the production of the field oxide of an integrated circuit in first regions (20b) of a doped semiconductor substrate (20) which are adjacent to a second region (20a) of the said substrate, in which region there will be produced an active component of the integrated circuit, characterized in that it comprises the following successive stages :

a) deposition of a protective layer (22) over the whole substrate (20),

b) masking of the region (22a) of the protective layer which is situated on the second region (20a) of the substrate, using resin (24),

c) removal of the regions (22b) of the protective layer which are situated above the first regions (20b) of the substrate (20),

d) producing a first etching of the first regions (20b) of the substrate (20) over a depth not exceeding 0.8 µm,

e) implantation of ions in the first regions (20b) of the remaining substrate, giving a doping of the same type as that of the substrate (20), while the resin is used as a mask,

f) removal of the resin mask (24),

g) deposition of a layer of insulator (32) over the entire substrate (20),

h) deposition of a layer of resin (34) on the layer of insulator (32), and

i) production of a second simultaneous etching of the layer of resin (34) and of the layer of insulator (32) until the region (32a) of the layer of insulator which is situated above the second region (20a) of the substrate (20) has been completely removed, and

j) removal of the region (22a) of the protective layer which is situated on the second region (20a) of the substrate (20).

2. Production process according to Claim 1, characterized in that the said second etching is performed using identical rates of etching for the resin (34) and the insulator (32).

3. Production process according to either of Claims 1 and 2, characterized in that the said second etching is a reactive ion etching, in a gaseous mixture containing either trifluoromethane and oxygen, or carbon tetrafluoride $CF_4$ and oxygen, or sulphur hexafluoride $SF_6$.

4. Production process according to any one of Claims 1 to 3, characterized in that stage c is performed with the aid of a reactive ion etching.

5. Production process according to any one of Claims 1 to 4, characterized in that stage j is performed with the aid of chemical etching.

6. Production process according to any one of Claims 1 to 5, characterized in that a slope etching of the first regions (20b) of the substrate (20) is performed during stage d.

7. Production process according to Claim 6, characterized in that a slope etching is performed with the aid of a slope profile of the resin mask (24) produced during stage b, and of an anisotropic reactive ion etching.

8. Production process according to Claim 7, characterized in that, in order to obtain a slope profile of the resin mask (24), this resin (24) is subjected to a heat treatment after its development.

9. Production process according to Claim 7, characterized in that, in order to obtain a slope profile of the resin mask (24), this resin (24) is subjected to an oxygen plasma after its development.

10. Production process according to any one of Claims 1 to 9, characterized in that a thermal oxidation of the substrate (20) is performed after stage f and before stage 9.

11. Production process according to any one of Claims 1 to 10, characterized in that the insulator layer (32) is made of silica.

12. Production process according to any one of Claims 1 to 11, characterized in that the protective layer (22) is made of silicon nitride.

### Patentansprüche

1. Verfahren zur Herstellung von Feldoxid für eine integrierte Schaltung in ersten Bereichen (20b) eines dotierten Halbleitersubstrats (20) benachbart einem zweiten Bereich (20a) des genannten Substrats, in welchem ein aktives Element der integrierten Schaltung ausgebildet ist, dadurch gekennzeichnet, daß es die folgenden Schritte umfaßt :

a) Aufbringen einer Schutzschicht (22) auf dem gesamten Substrat (20),

b) Maskierung des Bereiches (22a) der Schutzschicht, der auf dem zweiten Bereich (22a) des Substrats liegt, mit Harz (24),

c) Entfernen der Bereiche (22b) der Schutzschicht, die über den ersten Bereichen (20b) des Substrats (20) liegen,

d) Ausbilden einer ersten Vertiefung in den ersten Bereichen (20b) des Substrats (20) mit einer Höhe von maximal 0,8 µm,

e) Implantierung von Ionen in den ersten Bereichen (20b) des übriggebliebenen Substrats, die eine Dotierung desselben Typs wie die des Substrats (20) ergeben unter Verwendung des Harzes als Maske,

f) Entfernen der Harzmaske (24),

g) Aufbringen einer Isolierschicht (32) auf das gesamte Substrat (20),

h) Aufbringen einer Harzschicht (34) auf die Isolierschicht (32), und

i) Herstellen einer zweiten gleichzeitigen Vertiefung in der Harzschicht (34) und der Isolierschicht (32) bis zur vollständigen Entfernung des Bereiches (32a) der Isolierschicht, der über dem zweiten Bereich (20a) des Substrats (20) liegt, und

j) Entfernen des Bereiches (22a) der Schutzschicht, die auf dem zweiten Bereich (20a) des Substrats (20) liegt.

2. Herstellverfahren nach Anspruch 1, dadurch gekennzeichnet, daß man die zweite Vertiefung mit übereinstimmenden Angriffsgeschwindigkeiten für das Harz (34) und den Isolator (32) ausführt.

3. Herstellverfahren nach einem der Ansprüche 1 und 2, dadurch gekennzeichnet, daß die zweite Vertiefung eine reaktive ionische Gravur in einem Gasgemisch ist, das entweder Trifluormethan und Sauerstoff oder Tetrafluorkohlenstoff $CF_4$ und Sauerstoff oder Schwefelhexafluorid $SF_6$ enthält.

4. Herstellverfahren nach einem der Ansprüche 1 bis 3, dadurch gekennzeichnet, daß der Schritt c mit Hilfe einer reaktiven ionischen Gravur ausgeführt wird.

5. Herstellverfahren nach einem der Ansprüche 1 bis 4, dadurch gekennzeichnet, daß der Schritt j mit Hilfe einer chemischen Gravur ausgeführt wird.

6. Herstellverfahren nach einem der Ansprüche 1 bis 5, dadurch gekennzeichnet, daß man eine schräge Gravur der ersten Bereiche (20b) des Substrats (20) während des Schrittes d ausführt.

7. Herstellverfahren nach Anspruch 6, dadurch gekennzeichnet, daß man eine schräge Gravur mit Hilfe eines schrägen Profils der Harzmaske (24), die im Schritt b hergestellt wird, und mit einer reaktiven, anisotropen ionischen Gravur ausführt.

8. Herstellverfahren nach Anspruch 7, dadurch gekennzeichnet, daß man zur Erzielung eines schrägen Profils der Harzmaske (24) dieses Harz (24) einer thermischen Behandlung nach seiner Entwicklung unterwirft.

9. Herstellverfahren nach Anspruch 7, dadurch gekennzeichnet, daß man zur Erzielung eines schrägen Profils der Harzmaske (24) dieses Harz (24) nach seiner Entwicklung einem Sauerstoffplasma unterwirft.

10. Herstellverfahren nach einem der Ansprüche 1 bis 9, dadurch gekennzeichnet, daß man nach dem Schritt f und vor dem Schritt g eine thermische Oxidation des Substrats (20) ausführt.

11. Herstellverfahren nach einem der Ansprüche 1 bis 10, dadurch gekennzeichnet, daß die Isolierschicht (32) aus Siliciumoxid besteht.

12. Herstellverfahren nach einem der Ansprüche 1 bis 11, dadurch gekennzeichnet, daß die Schutzschicht (22) aus Siliciumnitrat besteht.

FIG. 1

FIG. 2

FIG. 3

FIG. 4

1

FIG. 5

FIG. 6

FIG. 7

FIG. 8

FIG. 9

FIG. 10